# EUROPEAN PATENT APPLICATION

(11) **EP 4 750 243 A1**
(43) Date of publication of application: **27.05.2026**
(21) Application number: 25217252.3
(22) Date of filing: 20.11.2025
(51) Int. Cl.: H10B 12/00, H10D 30/01, H10D 30/63, H10D 30/67

(54) **SEMICONDUCTOR DEVICE**

(30) Priority: 26.11.2024 KR 20240171471
(71) Applicant: Samsung Electronics Co., Ltd., Suwon-si, Gyeonggi-do 16677 (KR)
(72) Inventor: LEE, Chankyu, 16677 Suwon-si, Gyeonggi-do (KR); YOO, Sungwon, 16677 Suwon-si, Gyeonggi-do (KR); LEE, Seungmin, 16677 Suwon-si, Gyeonggi-do (KR); LEE, Hyunjae, 16677 Suwon-si, Gyeonggi-do (KR)
(74) Representative: Kuhnen & Wacker Patent- und Rechtsanwaltsbüro PartG mbB

(57) **Abstract**

A semiconductor device includes a capacitor structure (CAP), a buried contact (BC) on the capacitor structure (CAP), a hollow semicylindrical-shaped vertical channel layer (140) extending on the buried contact (BC) in a vertical direction (Z) and having an inner wall and an outer wall, a hollow semicylindrical-shaped gate dielectric layer (150) surrounding the outer wall of the vertical channel layer (140) and having an inner wall and an outer wall, word lines (WL) spaced apart from each other in a first horizontal direction (X) and extending in a second horizontal direction intersecting the first horizontal direction (X), a semicylindrical-shaped direct contact (DC) in contact with the inner wall of the vertical channel layer (140), and a bit line (BL) having a post (183) in contact with an upper surface of the direct contact (DC) and extending in the first horizontal direction (X). One of the word lines (WL) is in contact with the outer wall of the gate dielectric layer (150).

## Description

### BACKGROUND

The inventive concepts relate to semiconductor devices, and more particularly, to semiconductor devices including a vertical channel transistor.

To satisfy improved performance and/or economic feasibility, it is desired to increase the integration of a semiconductor device. In particular, the integration of a memory device is a critical or important factor in determining the economic feasibility of a product. The integration of a two-dimensional memory device is mainly determined by an area occupied by a unit memory cell and is thus significantly influenced by the level of a fine pattern forming technique. However, to form a fine pattern, expensive pieces of equipment are needed, and the area of a chip die is limited, and thus, the integration of a two-dimensional memory device is increasing but still limited.

### SUMMARY

Some example embodiments of the inventive concepts provide semiconductor devices including a vertical channel transistor and having improved integration and electrical characteristics, thereby improving the performance of a product.

The problems to be solved by the inventive concepts are not limited to the problem mentioned above, and other problems could be clearly understood by those of ordinary skill in the art from the description below.

According to an example embodiment of the inventive concepts, a semiconductor device includes a capacitor structure, a buried contact on the capacitor structure, a hollow semicylindrical-shaped vertical channel layer extending on the buried contact in a vertical direction, the vertical channel layer having an inner wall and an outer wall, a hollow semicylindrical-shaped gate dielectric layer surrounding the outer wall of the vertical channel layer, the gate dielectric layer having an inner wall and an outer wall, word lines each in contact with the outer wall of the gate dielectric layer, the word lines spaced apart from each other in a first horizontal direction, the word lines extending in a second horizontal direction intersecting the first horizontal direction, a semicylindrical-shaped direct contact in contact with the inner wall of the vertical channel layer, and a bit line having a post in contact with an upper surface of the direct contact, the bit line extending in the first horizontal direction.

According to an example embodiment of the inventive concepts, a semiconductor device includes a pair of capacitor structures facing each other, a pair of buried contacts facing each other, the pair of buried contacts being on the pair of capacitor structures, respectively, a pair of vertical channel layers extending on the pair of buried contacts in a vertical direction, respectively, the pair of vertical channel layers facing each other and having hollow semicylindrical shapes with a first radius, a pair of gate dielectric layers surrounding the pair of vertical channel layers, respectively, the pair of gate dielectric layers facing each other and having hollow semicylindrical shapes with a second radius, the second radius being greater than the first radius, word lines spaced apart from each other in a first horizontal direction, the word lines extending in a second horizontal direction intersecting the first horizontal direction, one of the word lines being in contact with one of the pair of gate dielectric layers, a pair of direct contacts in contact with inner sides of the pair of vertical channel layers, respectively, the pair of direct contacts having semicylindrical shapes and facing each other, and a bit line extending in the first horizontal direction, the bit line having a pair of posts in contact with upper surfaces of the pair of direct contacts, respectively.

According to an example embodiment of the inventive concepts, a semiconductor device includes a capacitor structure, a buried contact on the capacitor structure, a vertical channel layer extending on the buried contact in a vertical direction, the vertical channel layer including an oxide semiconductor material, the vertical channel layer having an inner wall and an outer wall, a gate dielectric layer on the outer wall of the vertical channel layer, the gate dielectric layer having an inner wall and an outer wall, word lines each coming in contact with the outer wall of the gate dielectric layer, the word lines spaced apart from each other in a first horizontal direction, the word lines extending in a second horizontal direction intersecting the first horizontal direction, a direct contact in contact with the inner wall of the vertical channel layer, and a bit line extending in the first horizontal direction, the bit line having a post in contact with an upper surface of the direct contact, wherein an uppermost surface of the direct contact, an uppermost surface of the vertical channel layer, an uppermost surface of the gate dielectric layer, and an uppermost surface of the word lines are at a same vertical level.

According to an example embodiment of the inventive concepts, a method of manufacturing a semiconductor device includes forming a first insulating layer on a substrate, forming a plurality of capacitor structures each extending through the first insulating layer, forming a second insulating layer on the first insulating layer and the plurality of capacitor structures, forming a plurality of buried contacts each extending through the second insulating layer, forming a mold preparation layer and a sacrificial layer in sequence on the second insulating layer and the plurality of buried contact, patterning the sacrificial layer and the mold preparation layer to form a plurality of sacrificial pattern layers and a plurality of mold pattern layers on the plurality of buried contacts, respectively, forming a channel pattern layer on a cylindrical-shaped sidewall of a corresponding one of the plurality of mold pattern layers, forming a gate dielectric preparation layer to conformally cover exposed surfaces of the second insulating layer, the channel pattern layer, and the plurality of sacrificial pattern layer, forming a word line preparation layer to cover the gate dielectric preparation layer, etching the word line preparation layer until upper surfaces of the plurality of sacrificial pattern layers, an upper surface of the plurality of channel pattern layer, and an upper surface of the gate dielectric preparation layer are exposed, forming an upper capping preparation layer on the upper surfaces of the plurality of sacrificial pattern layers, the upper surface of the channel pattern layer, the upper surface of the gate dielectric preparation layer, and an upper surface of the word line preparation layer, patterning the upper capping preparation layer, the plurality of sacrificial pattern layers, the channel pattern layer, the gate dielectric preparation layer, and the word line preparation layer to form an upper capping layer, a sacrificial structure layer, a vertical channel layer, a gate dielectric layer, and a word line, forming an outer capping layer to cover exposed surfaces of the mold layer, the sacrificial structure layer, the vertical channel layer, the gate dielectric layer, the word line, and the upper capping layer, forming an interlayer insulating material to cover the outer capping layer, forming a plurality of openings through which portions of upper surfaces of the sacrificial structure layer are exposed, respectively, removing the sacrificial structure layer through each of the plurality of openings to form a plurality of vacant spaces under the plurality of openings, forming a bit line preparation layer to fill the plurality of openings and the plurality of vacant spaces and to cover the upper surface of the interlayer insulating material, and patterning the bit line preparation layer to form a bit line.

### BRIEF DESCRIPTION OF THE DRAWINGS

Example embodiments of the inventive concepts will be more clearly understood from the following detailed description taken in conjunction with the accompanying drawings in which:
FIG. 1 is a perspective view illustrating some components of a semiconductor device according to an example embodiment;
FIG. 2 is a top view illustrating the semiconductor device of FIG. 1;
FIG. 3 is a cross-sectional view taken along line A-A' in the semiconductor device of FIG. 2;
FIG. 4 illustrates a honeycomb structure arrangement in the semiconductor device of FIG. 1;
FIG. 5 is an exploded perspective view illustrating a hollow semicylindrical shape in the semiconductor device of FIG. 1;
FIGS. 6A to 24B are perspective views and cross-sectional views illustrating, in a process order, a method of manufacturing a semiconductor device, according to an example embodiment; and
FIG. 25 is a block diagram illustrating a system including a semiconductor device according to an example embodiment.

### DETAILED DESCRIPTION

Hereinafter, some example embodiments are described in detail with reference to the accompanying drawings.

As used herein, expressions such as "one of," "one or more of," "any one of," and "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

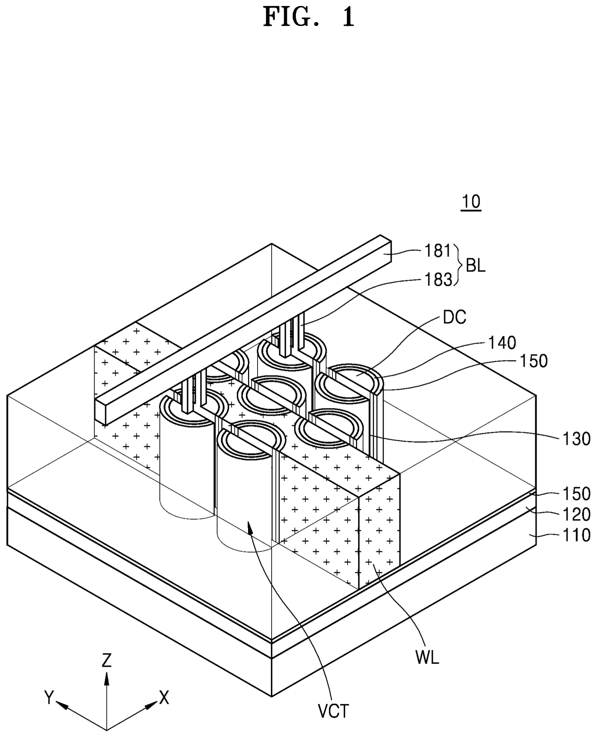

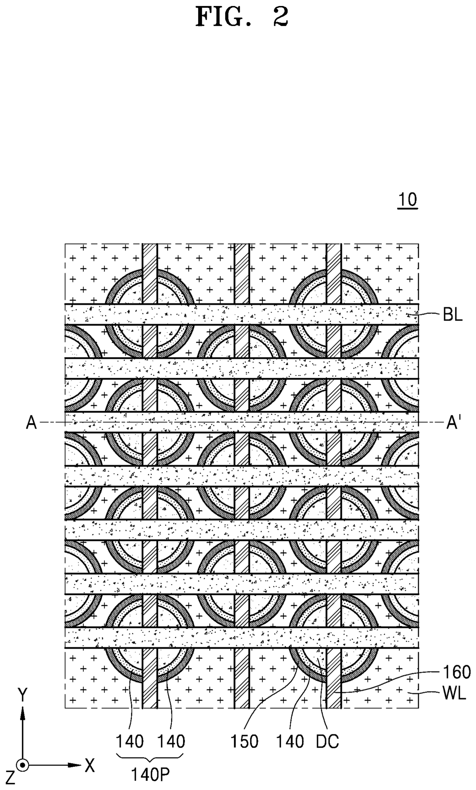

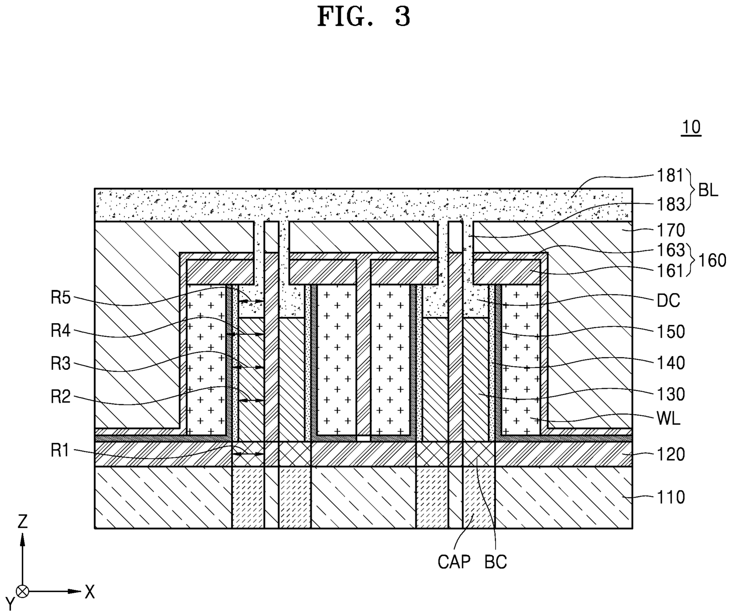

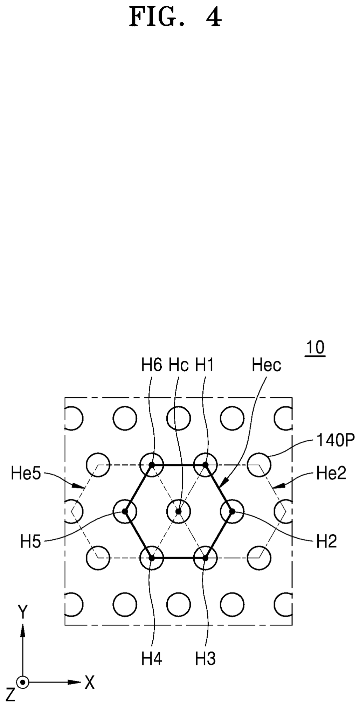

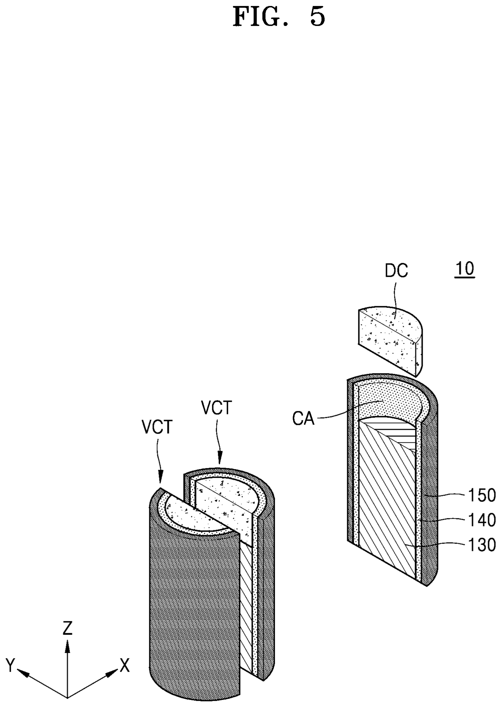

FIG. 1 is a perspective view illustrating some components of a semiconductor device 10 according to an example embodiment. FIG. 2 is a top view illustrating the semiconductor device 10 of FIG. 1. FIG. 3 is a cross-sectional view taken along line A-A' in the semiconductor device 10 of FIG. 2. FIG. 4 illustrates a honeycomb structure arrangement in the semiconductor device 10 of FIG. 1. FIG. 5 is an exploded perspective view illustrating a hollow semicylindrical shape in the semiconductor device 10 of FIG. 1.

For convenience of description and understanding, some components are omitted in some drawings. In addition, components transparently shown in some drawings may be actually not transparent.

Referring to FIGS. 1 to 5, the semiconductor device 10 according to an example embodiment may include memory cells including a vertical channel transistor VCT.

In the semiconductor device 10 of an example embodiment of the inventive concepts, a plurality of capacitor structures CAP may be arranged to be spaced apart from each other in a first horizontal direction (the X direction). In some example embodiments, each of the plurality of capacitor structures CAP may have a metal-insulator-metal-type capacitor. For example, each of the plurality of capacitor structures CAP may include a first electrode, a second electrode, and a capacitor dielectric layer between the first electrode and the second electrode.

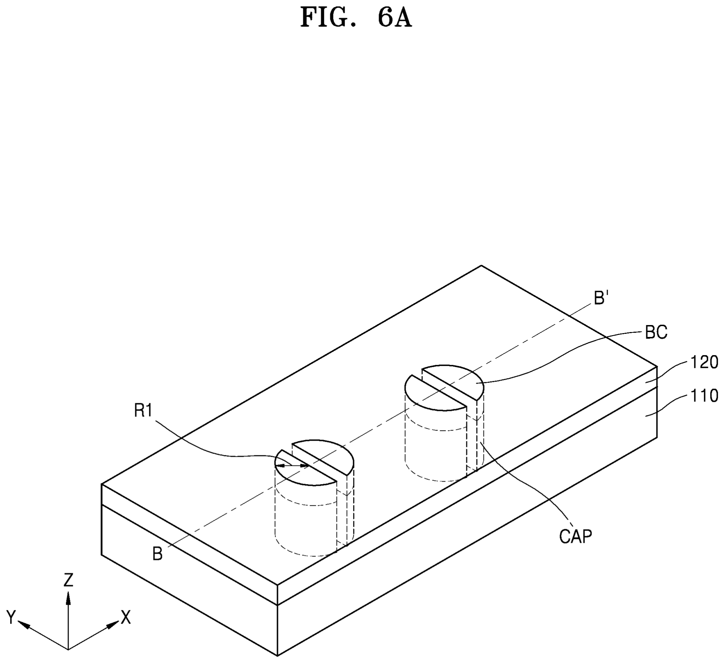

A plurality of buried contacts BC may be disposed on the plurality of capacitor structures CAP, respectively. Referring to FIG. 6A together, in some example embodiments, each of the plurality of buried contacts BC may have a semicylindrical shape having a first radius R1. In addition, in a top view, a pair of buried contacts BC facing each other may have a mirror-symmetric structure, and a virtual line drawn by the pair of buried contacts BC facing each other may have a circular shape. For example, the plurality of buried contacts BC may include any one of molybdenum (Mo), ruthenium (Ru), titanium nitride (TiN), or titanium (Ti).

A first insulating layer 110 and a second insulating layer 120 may be arranged to surround the plurality of capacitor structures CAP and the plurality of buried contacts BC, respectively. The first insulating layer 110 may surround the plurality of capacitor structures CAP and include, for example, silicon oxide, silicon nitride, silicon carbide, or a combination thereof. In addition, the second insulating layer 120 may surround the plurality of buried contacts BC and include, for example, silicon oxide, silicon nitride, silicon carbide, or a combination thereof. Herein, the first insulating layer 110 and the second insulating layer 120 may include different materials. For example, the first insulating layer 110 may include silicon oxide, and the second insulating layer 120 may include silicon nitride.

Each of a plurality of mold layers 130 may be formed on one portion of the upper surface of a corresponding one of the plurality of buried contacts BC. In some example embodiments, each of the plurality of mold layers 130 may have a semicylindrical shape having a second radius R2. In a top view, a pair of mold layers 130 facing each other may have a mirror-symmetric structure, and a virtual line drawn by the pair of mold layers 130 facing each other may have a circular shape. Herein, the second radius R2 of a mold layer 130 may be less than the first radius R1 of a buried contact BC. For example, the plurality of mold layers 130 may include silicon oxide.

Each of a plurality of vertical channel layers 140 may be disposed on the other portion of the upper surface of a corresponding one of the plurality of buried contacts BC. In some example embodiments, each of the plurality of vertical channel layers 140 may have a hollow semicylindrical shape (e.g., a half-pipe shape, same hereinafter) having a third radius R3. In a top view, a pair of vertical channel layers 140 facing each other may have a mirror-symmetric structure, and a virtual line drawn by the pair of vertical channel layers 140 facing each other may have a circular shape. Herein, the third radius R3 of a vertical channel layer 140 may be substantially the same as or less than the first radius R1 of the buried contact BC.

For convenience of description, a pair of vertical channel layers 140 are referred to as one vertical channel pair 140P. In the semiconductor device 10 of an example embodiment of the inventive concepts, a plurality of vertical channel pairs 140P may be arranged to have a honeycomb structure. A detailed description thereof is made below.

In the semiconductor device 10 of an example embodiment of the inventive concepts, the vertical channel layer 140 may be arranged to be in contact with a corresponding mold layer 130 while surrounding the outer wall of the corresponding mold layer 130. In addition, the length of the vertical channel layer 140 in the vertical direction (the Z direction) may be greater than the length of the corresponding mold layer 130 in the vertical direction (the Z direction). That is, a portion of the inner wall of the vertical channel layer 140 may be in contact with the corresponding mold layer 130, and the other portion of the inner wall of the vertical channel layer 140 may be in contact with a direct contact DC to be described below.

The vertical channel layer 140 may include an oxide semiconductor material. The oxide semiconductor material may include indium (In) and, for example, the oxide semiconductor material may include at least one of indium gallium zinc oxide (InGaZnOₓ (IGZO)), tin (Sn)-doped IGZO, tungsten (W)-doped IGZO, or indium zinc oxide (InZnOₓ (IZO)) but is not limited thereto.

A plurality of gate dielectric layers 150 may be arranged to be in contact with the plurality of vertical channel layers 140 while surrounding the outer walls of the plurality of vertical channel layers 140, respectively. In some example embodiments, each of the plurality of gate dielectric layers 150 may have a hollow semicylindrical shape having a fourth radius R4. In a top view, a pair of gate dielectric layers 150 facing each other may have a mirror-symmetric structure, and a virtual line drawn by the pair of gate dielectric layers 150 facing each other may have a circular shape. Herein, the fourth radius R4 of a gate dielectric layer 150 may be greater than the third radius R3 of the vertical channel layer 140.

The gate dielectric layer 150 may include a high-k dielectric material having a higher dielectric constant than that of silicon oxide. For example, the gate dielectric layer 150 may include hafnium dioxide (HfO₂), alumina (Al₂O₃), hafnium aluminum trioxide (HfAlO₃), ditantalum trioxide (Ta₂O₃), titanium dioxide (TiO₂), or a combination thereof but is not limited thereto.

A plurality of word lines WL may be in contact with the plurality of gate dielectric layers 150 arranged in a zigzag manner while surrounding the outer walls of the plurality of gate dielectric layers 150 and extend in a wave shape in a second horizontal direction (the Y direction). That is, one word line WL may be arranged to be in contact with only any one of a pair of gate dielectric layers 150. In addition, one sidewall of the word line WL may be parallel with one sidewall of the mold layer 130 and one sidewall of the direct contact DC to be described below. Herein, the plurality of word lines WL may be spaced apart from each other in the first horizontal direction (the X direction) and arranged to face each other. For example, the word line WL may include Ti, TiN, tantalum (Ta), tantalum nitride (TaN), W, tungsten nitride (WN), titanium silicon nitride (TiSiN), tungsten silicon nitride (WSiN), polysilicon, or a combination thereof.

A plurality of direct contacts DC may be disposed on the upper surfaces of the plurality of mold layers 130 to be in contact with the inner walls of the plurality of vertical channel layers 140, respectively. That is, the direct contact DC may be disposed such that the lower surface of the direct contact DC is not in contact with the vertical channel layer 140 and the rounded sidewall of the direct contact DC is in contact with the inner wall of the vertical channel layer 140. In some example embodiments, each of the plurality of direct contacts DC may have a semicylindrical shape having a fifth radius R5. In a top view, a pair of direct contacts DC facing each other may have a mirror-symmetric structure, and a virtual line drawn by the pair of direct contacts DC facing each other may have a circular shape. Herein, the fifth radius R5 of the direct contact DC may be substantially the same as the second radius R2 of the mold layer 130. In some example embodiments, the plurality of direct contacts DC may include the same material as that of a bit line BL to be described below.

A capping layer 160 may be disposed to conformally cover the vertical channel layer 140, the gate dielectric layer 150, the direct contact DC, and the word line WL. The capping layer 160 may be divided into an upper capping layer 161 and an outer capping layer 163 according to formed positions thereof.

The upper capping layer 161 may be disposed on the upper surface of the vertical channel layer 140, the uppermost surface of the gate dielectric layer 150, the upper surface of the direct contact DC, and the upper surface of the word line WL and extend in a bar shape in the second horizontal direction (the Y direction). In addition, the upper capping layer 161 may be disposed such that one sidewall of the upper capping layer 161 may be coplanar with the one sidewall of the word line WL, and one sidewall of the direct contact DC and the other sidewall of the upper capping layer 161 may be parallel with the other sidewall of the word line WL.

The outer capping layer 163 may be conformally disposed on a sidewall of the mold layer 130, a sidewall of the vertical channel layer 140, a sidewall of the gate dielectric layer 150, a sidewall of the direct contact DC, a sidewall of the word line WL, and the upper capping layer 161 and disposed while filling the space between two adjacent word lines WL. In some example embodiments, the upper capping layer 161 and the outer capping layer 163 may include the same insulating material, for example, silicon nitride.

An interlayer insulating layer 170 may be disposed to cover the capping layer 160. The interlayer insulating material 170 may be formed on the outer capping layer 163 and have a flat upper surface. In some example embodiments, the interlayer insulating material 170 and the capping layer 160 may include different insulating materials, and the interlayer insulating material 170 may include, for example, silicon oxide.

The bit line BL may be disposed on the interlayer insulating material 170 to extend in the first horizontal direction (the X direction). A bit line insulating layer (not shown) extending in the first horizontal direction (the X direction) may be disposed on a sidewall of the bit line BL. For example, the bit line insulating layer may be formed with the same height as that of the bit line BL while filling the space between two adjacent bit lines BL. For example, the bit line BL may include Ti, TiN, Ta, TaN, W, WN, TiSiN, WSiN, polysilicon, or a combination thereof.

The bit line BL may include a horizontal extension portion 181 extending lengthwise in the first horizontal direction (the X direction) and a plurality of posts 183 protruding in the vertical direction (the Z direction) from the horizontal extension portion 181. One post 183 in the bit line BL may be disposed such that the lower surface of the one post 183 is in contact with the upper surface of a corresponding direct contact DC. In some example embodiments, the post 183 may be disposed such that a lower region thereof is in contact with the capping layer 160 and an upper region thereof is in contact with the interlayer insulating material 170. That is, the post 183 may be in contact with the direct contact DC through the capping layer 160 and the interlayer insulating material 170.

The horizontal extension portion 181, the post 183, and the direct contact DC may be integrated into one body. Accordingly, the bit line BL and the direct contact DC may include the same material. According to circumstances, the horizontal extension portion 181, the post 183, and the direct contact DC may be referred to as the bit line BL.

Next, an arrangement of the honeycomb structure of the plurality of vertical channel pairs 140P is described. Although FIG. 4 illustrates an arrangement of the plurality of vertical channel pairs 140P, the description of the arrangement of the honeycomb structure may also be applied in the same or substantially similar manner to a pair of buried contacts BC, a pair of mold layers 130, a pair of direct contacts DC, and a pair of gate dielectric layers 150.

The honeycomb structure may have a structure in which the plurality of vertical channel pairs 140P are disposed at first to sixth vertices H1, H2, H3, H4, H5, and H6 and a central point Hc of a hexagon. As shown in FIG. 4, the plurality of vertical channel pairs 140P may be disposed in a structure in which the honeycomb structure continues in the first horizontal direction (the X direction) and the second horizontal direction (the Y direction) in an overlapping manner.

The plurality of vertical channel pairs 140P may be disposed in a structure in which each of the six (e.g., the first to sixth vertices H1, H2, H3, H4, H5, and H6) of a central hexagon Hec (shown by a solid line) may be the central point of each of the six hexagons arranged adjacent to the central hexagon Hec and the central point Hc of the central hexagon Hec is shared by the six hexagons.

For example, the second vertex H2 may be the central point of a second hexagon He2 (shown by an alternate long and short dash line), the fifth vertex H5 may be the central point of a fifth hexagon He5 (shown by a dashed line), and the central point Hc of the central hexagon Hec may be shared as one of the six vertices of each of the second hexagon He2 and the fifth hexagon He5.

Herein, in the honeycomb structure of the plurality of vertical channel pairs 140P, the hexagons may be regular hexagons. In addition, all the six triangles sharing the central point Hc of the central hexagon Hec may be regular triangles. Accordingly, in one hexagon, the distance between every two adjacent vertices or between each vertex and the central point may be identical.

In addition, unlike FIG. 1 showing that each of the plurality of vertical channel pairs 140P is divided into two semicircles, FIG. 4 shows that each of the plurality of vertical channel pairs 140P has a circular shape. This is for convenience of description, and each of the plurality of vertical channel pairs 140P in the semiconductor device 10 may actually have a shape of two semicircles (two hollow semicylinders in the perspective view) facing each other, as shown in FIG. 1.

In some example embodiments, in a top view, when the central hexagon Hec of FIG. 4 is applied to FIG. 2, the number of bit lines BL passing through the inside of the central hexagon Hec may be greater than the number of word lines WL passing through the inside of the central hexagon Hec. In addition, in some example embodiments, in a top view, the bit line BL may pass through the central point Hc of the central hexagon Hec, and the word line WL may not pass through the central point Hc of the central hexagon Hec.

To realize improved performance and/or economic feasibility, it is desired to increase the integration of a semiconductor device. In particular, the integration of a memory device is a critical or important factor to determine the economic feasibility of a product. The integration of a two-dimensional memory device is mainly determined by an area occupied by a unit memory cell and is thus significantly influenced by the level of a fine pattern forming technique. However, to form a fine pattern, expensive pieces of equipment are needed, and the area of a chip die is limited, and thus, the integration of a two-dimensional memory device is increasing but still is limited. Therefore, the demand for a semiconductor device including a vertical channel transistor has increased, and a method of further increasing the integration of the vertical channel transistor has been devised.

In general, in a semiconductor device including a vertical channel transistor, when a vertical channel layer is formed along a sidewall of a mold layer having a rectangular parallelepiped shape, an increase in the integration of the vertical channel transistor is limited. In addition, when the size of the vertical channel transistor is reduced to improve the integration, the contact area between a direct contact and a vertical channel layer may decrease. This may cause deterioration of electrical characteristics of the semiconductor device according to a high contact resistance in the semiconductor device.

To solve this problem, in the semiconductor device 10 according to an example embodiment of the inventive concepts, circular-shaped vertical channel pairs 140P are disposed in the honeycomb structure to improve the integration of the vertical channel transistor VCT. In addition, the circular-shaped vertical channel pair 140P may be divided into two hollow semicylindrical-shaped vertical channel layers 140, thereby expecting further improvement of integration.

In addition, in the semiconductor device 10 according to an example embodiment of the inventive concepts, to increase a contact area CA between the direct contact DC and the vertical channel layer 140, the direct contact DC may be formed to be in contact with the inner wall of the vertical channel layer 140 having a hollow semicylindrical shape. That is, by using the curved surface-shaped inner wall of the vertical channel layer 140, the contact area CA between the direct contact DC and the vertical channel layer 140 may be increased. That is, because the contact area CA may be increased to reduce a contact resistance, deterioration of the electrical characteristics of the semiconductor device 10 may be reduced or prevented.

Eventually, the semiconductor device 10 according to an example embodiment of the inventive concepts may have a relatively high degree of integration through the vertical channel transistor VCT disposed in the honeycomb structure and reduce a contact resistance through the direct contact DC in curved contact with the vertical channel layer 140 that has a hollow semicylindrical shape to improve the electrical characteristics of the semiconductor device 10, thereby improving the performance of a product.

FIGS. 6A to 24B are perspective views and cross-sectional views illustrating, in a process order, a method of manufacturing a semiconductor device, according to an example embodiment.

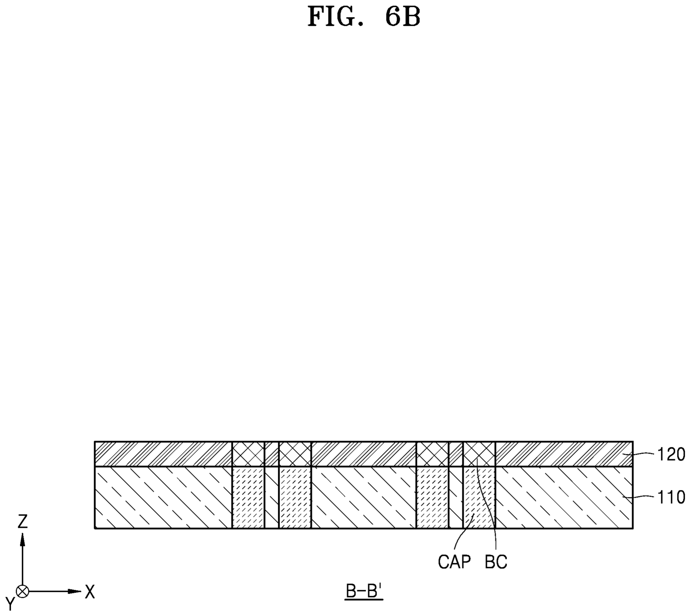

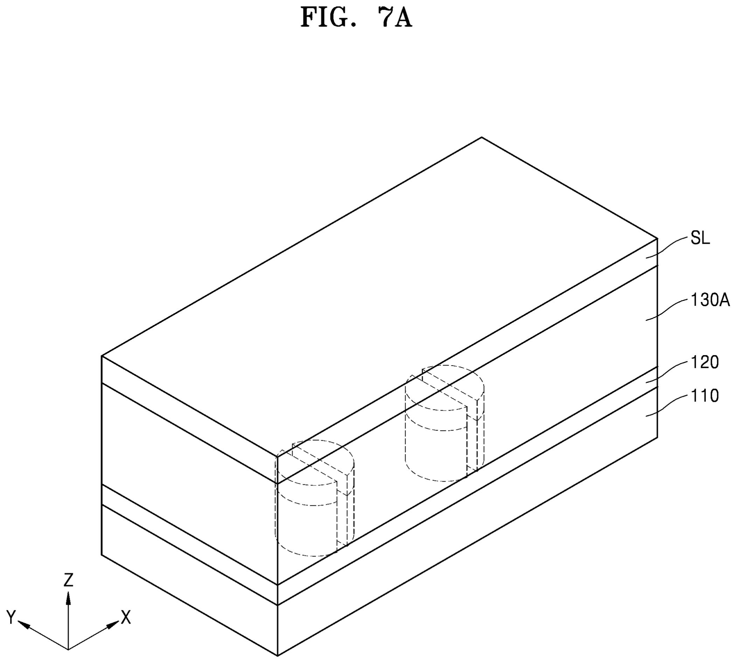

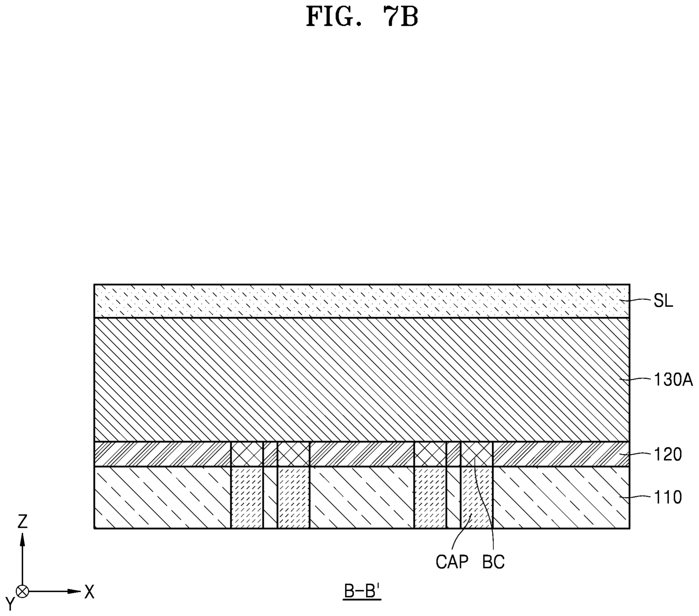

Particularly, FIGS. 6A, 7A, ..., and 24A are perspective views illustrating some components, and FIGS. 6B, 7B, ..., and 24B are cross-sectional views taken along line '-B' of FIG. 6A in FIGS. 6A, 7A, ..., and 24A, respectively.

Referring to FIGS. 6A and 6B, the plurality of capacitor structures CAP may be formed on a substrate (not shown), and the plurality of buried contacts BC may be formed on the plurality of capacitor structures CAP, respectively.

The first insulating layer 110 may be first formed on the substrate, a plurality of capacitor opening portions passing through the first insulating layer 110 may be formed, and the plurality of capacitor structures CAP may be formed in the plurality of capacitor opening portions, respectively.

Next, the plurality of buried contacts BC may be formed on the plurality of capacitor structures CAP, respectively, and the second insulating layer 120 covering sidewalls of the plurality of buried contacts BC may be formed. For example, the first insulating layer 110 may include silicon oxide, and the second insulating layer 120 may include silicon nitride.

Each of the plurality of buried contacts BC may have a semicylindrical shape having the first radius R1. A pair of buried contacts BC facing each other may have a mirror-symmetric structure, and a virtual line drawn by the pair of buried contacts BC facing each other may have a circular shape. Although FIG. 6A shows that the plurality of capacitor structures CAP and the plurality of buried contacts BC have the same semicylindrical shape, the shape of the plurality of capacitor structures CAP is not limited thereto.

Referring to FIGS. 7A and 7B, a mold preparation layer 130A may be formed on the plurality of buried contacts BC and the second insulating layer 120. For example, the mold preparation layer 130A may include silicon oxide.

Next, a sacrificial layer SL may be formed on the mold preparation layer 130A. The sacrificial layer SL may be formed of a material, for example, a spin on mask (SOH) or silicon carbide, to be easily removed in a post process.

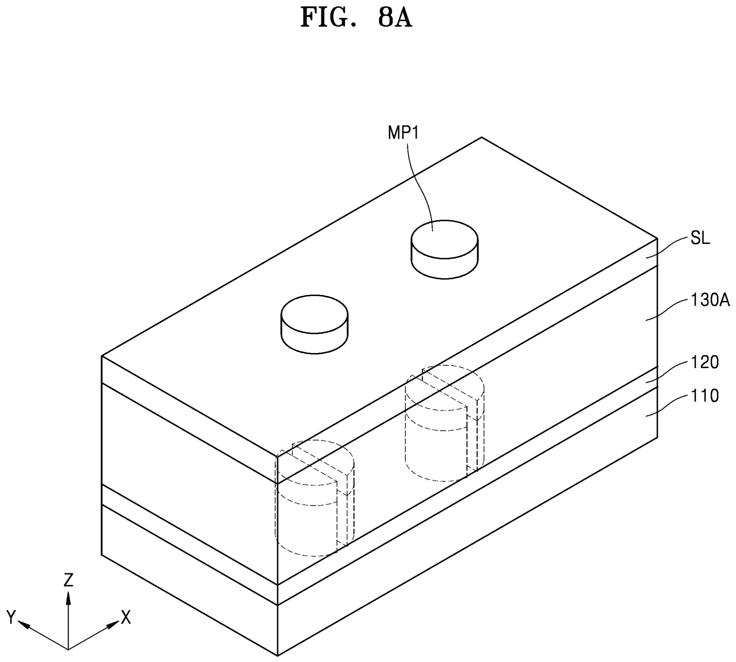

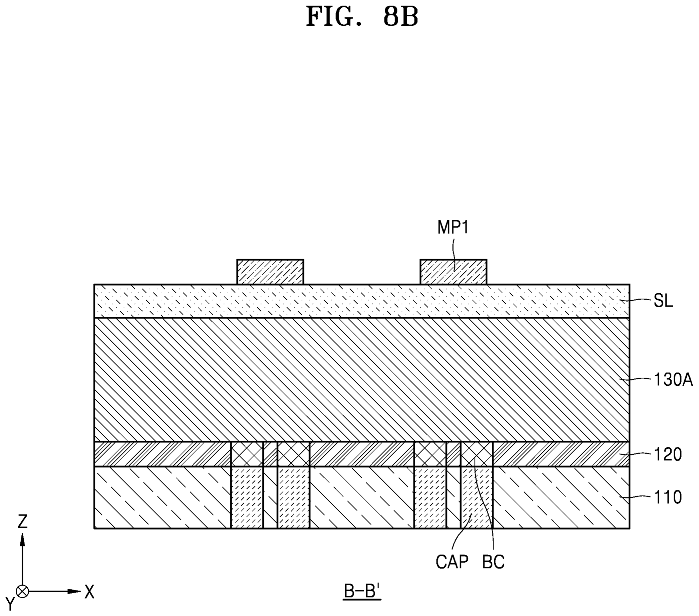

Referring to FIGS. 8A and 8B, a first photoresist may be applied on the sacrificial layer SL and then patterned by a first photolithography process to form a first mask pattern MP1. A region in which a plurality of mold pattern layers 130B to be described below is to be formed may be defined by the first mask pattern MP1.

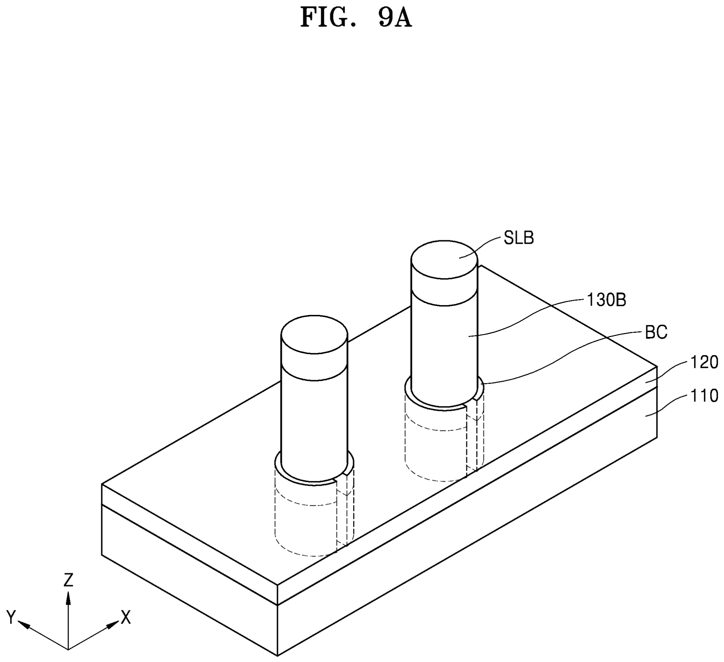

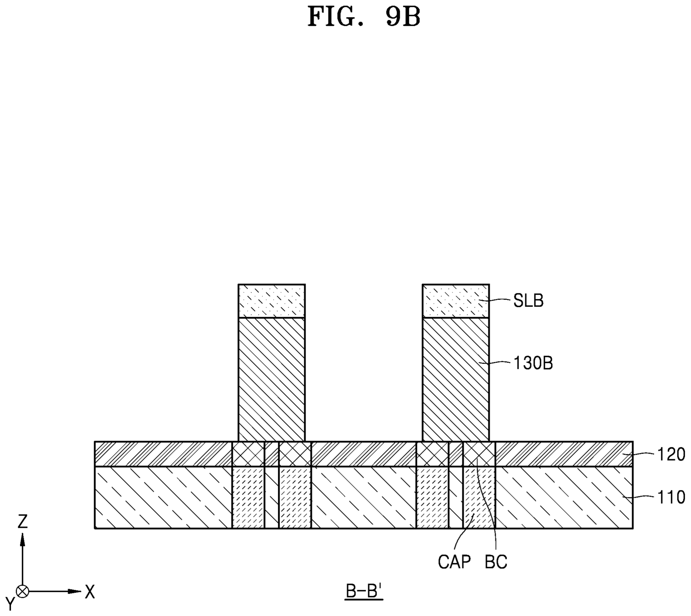

Referring to FIGS. 9A and 9B, an etching process using the first mask pattern MP1 (see FIG. 8A) as an etching mask may be performed to form the plurality of mold pattern layers 130B and a plurality of sacrificial pattern layers SLB on the plurality of buried contacts BC, respectively.

According to the etching process, a mold pattern layer 130B and a sacrificial pattern layer SLB having a cylindrical shape may be formed on a pair of buried contacts BC facing each other. In addition, according to the etching process, portions of the upper surfaces of the plurality of buried contacts BC and the upper surface of the second insulating layer 120 may be exposed. After the etching process, the first mask pattern MP1 (see FIG. 8A) may be removed.

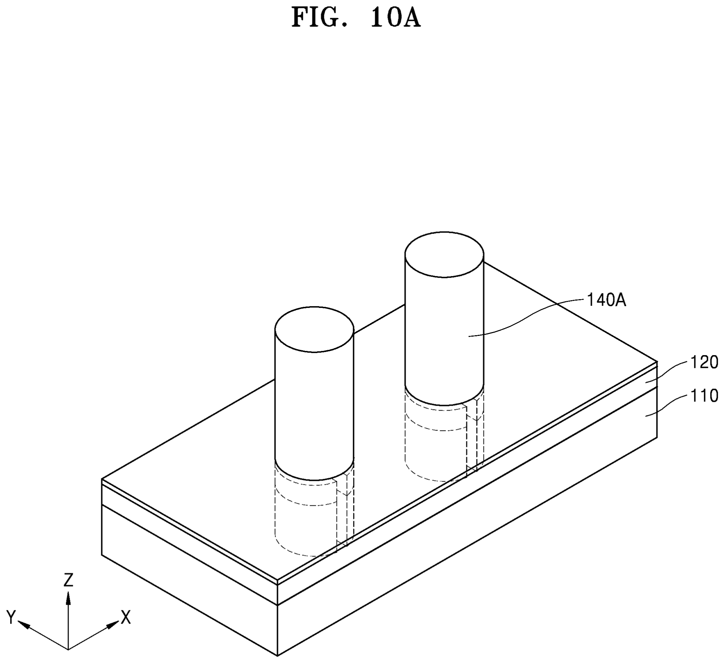

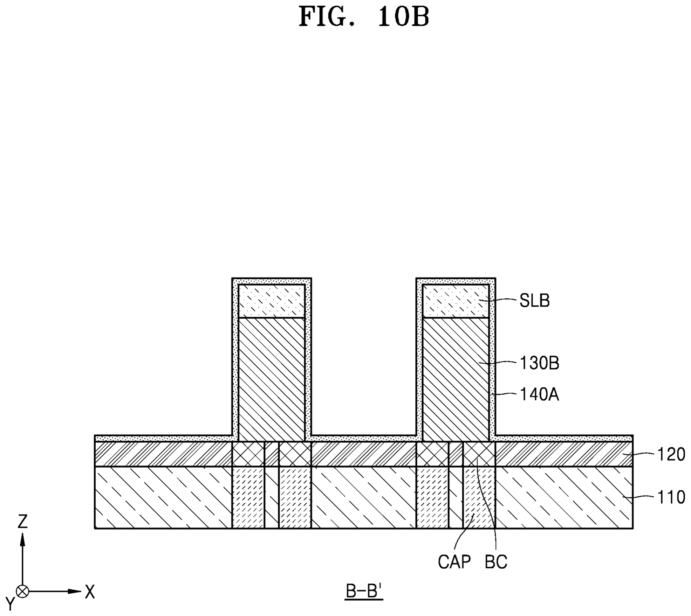

Referring to FIGS. 10A and 10B, a channel preparation layer 140A may be formed to conformally cover exposed surfaces of the second insulating layer 120, the buried contact BC, the mold pattern layer 130B, and the sacrificial pattern layer SLB. For example, the channel preparation layer 140A may include the oxide semiconductor material described above.

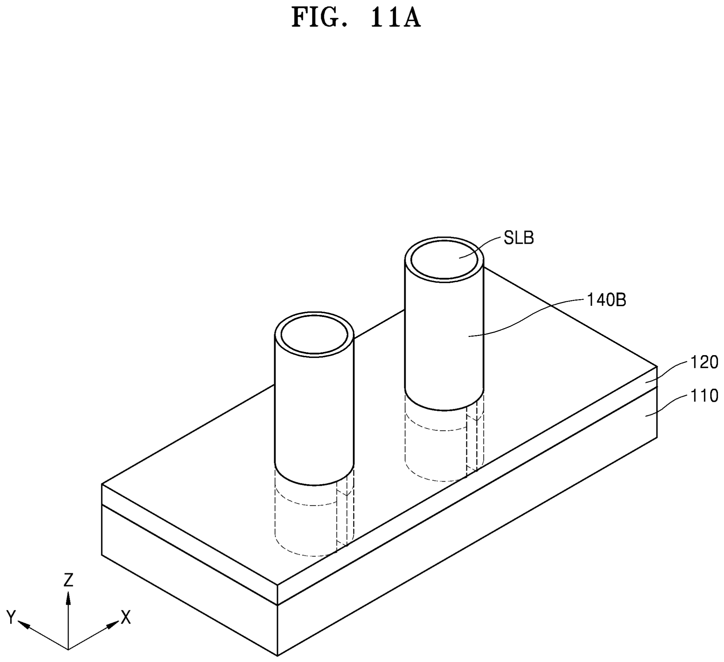

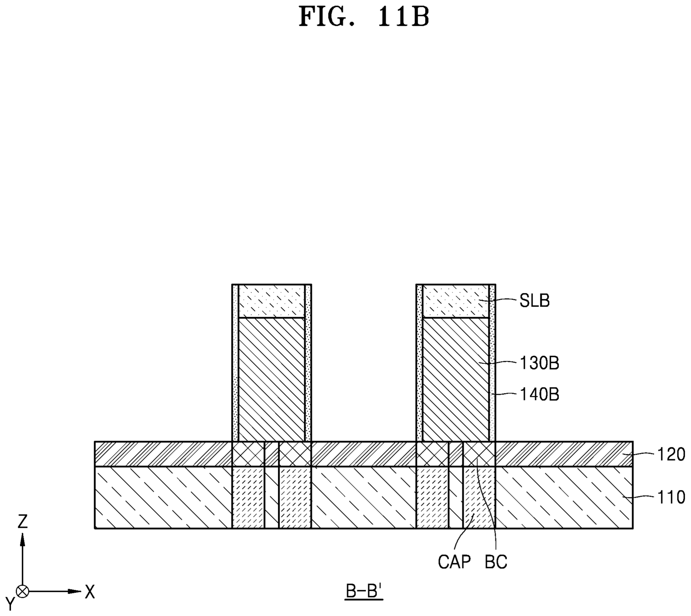

Referring to FIGS. 11A and 11B, an etch back process may be performed on the channel preparation layer 140A (see FIG. 10A) to form a channel pattern layer 140B only on a cylindrical-shaped sidewall formed by the mold pattern layer 130B and the sacrificial pattern layer SLB. Accordingly, the channel pattern layer 140B may have a hollow cylindrical-shaped structure. In addition, according to the etch back process, the upper surface of the second insulating layer 120 may be exposed again.

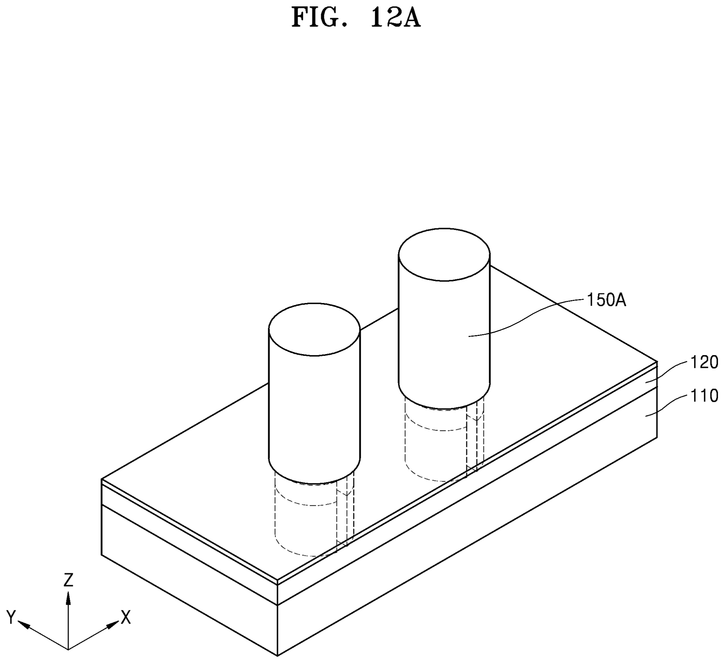

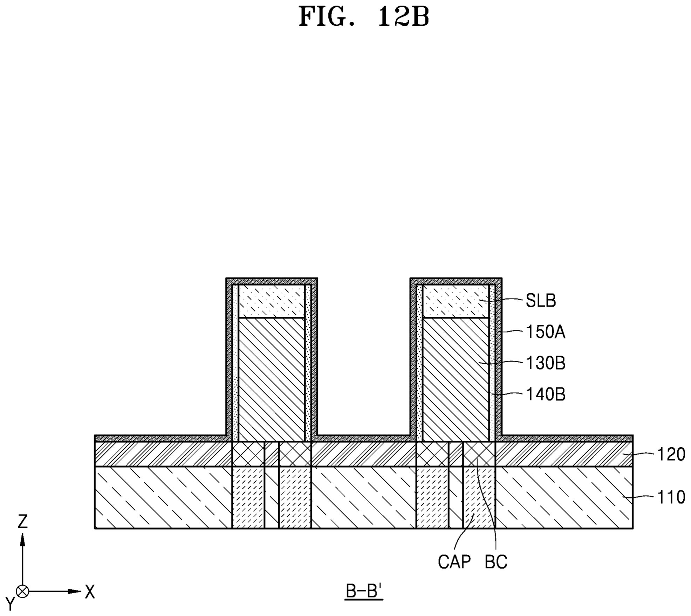

Referring to FIGS. 12A and 12B, a gate dielectric preparation layer 150A may be formed to conformally cover exposed surfaces of the second insulating layer 120, the channel pattern layer 140B, and the sacrificial pattern layer SLB. For example, the gate dielectric preparation layer 150A may include the high-k dielectric material described above.

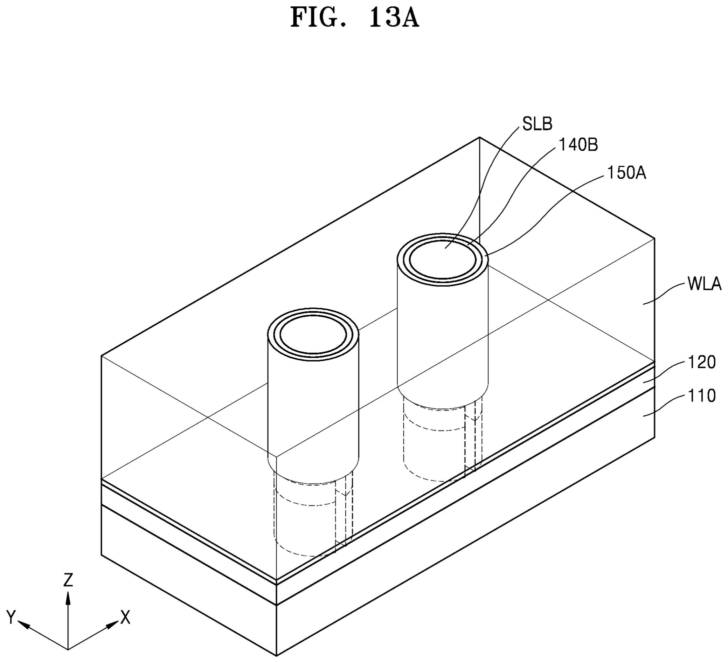

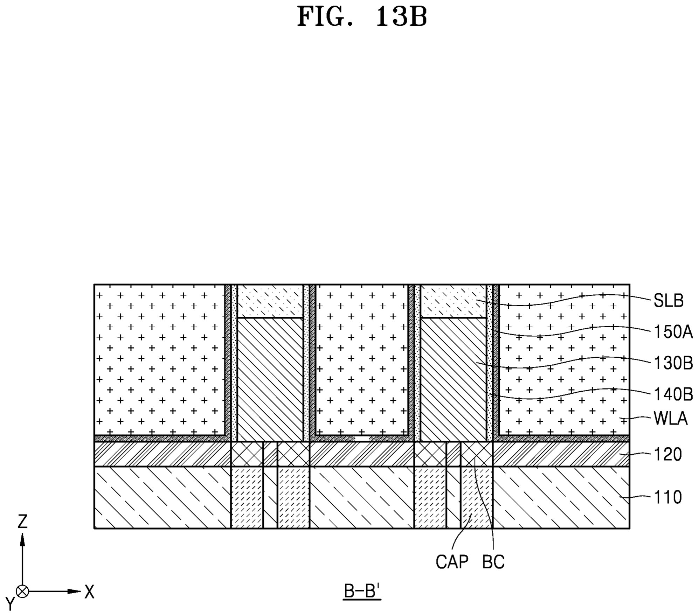

Referring to FIGS. 13A and 13B, a word line preparation layer WLA may be formed to cover the gate dielectric preparation layer 150A. For example, the word line preparation layer WLA may include Ti, TiN, Ta, TaN, W, WN, TiSiN, WSiN, polysilicon, or a combination thereof.

Next, the word line preparation layer WLA may be etched back or polished to form a flat surface through which the upper surface of the sacrificial pattern layer SLB, the upper of the channel pattern layer 140B, and the upper surface of the gate dielectric preparation layer 150A are exposed. Accordingly, the upper surface of the sacrificial pattern layer SLB, the upper surface of the channel pattern layer 140B, the upper surface of the gate dielectric preparation layer 150A, and the upper surface of the word line preparation layer WLA may be coplanar with each other.

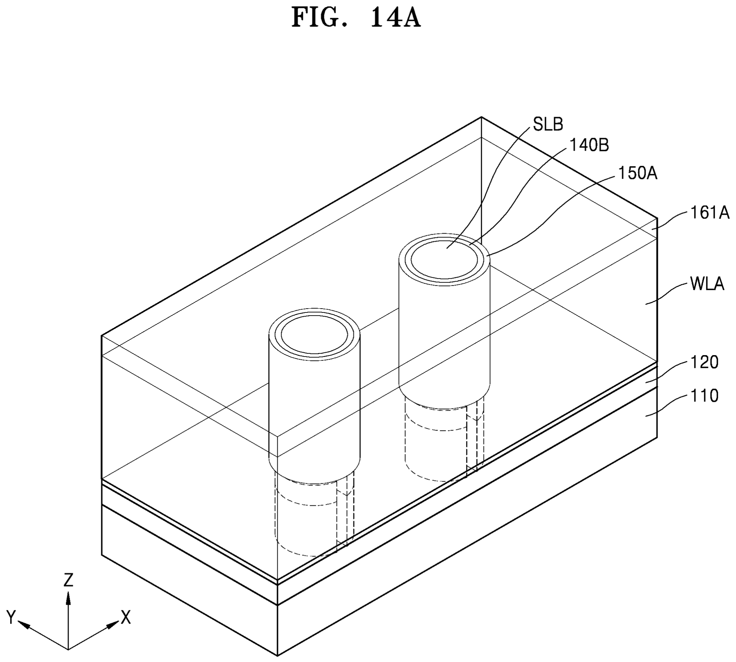

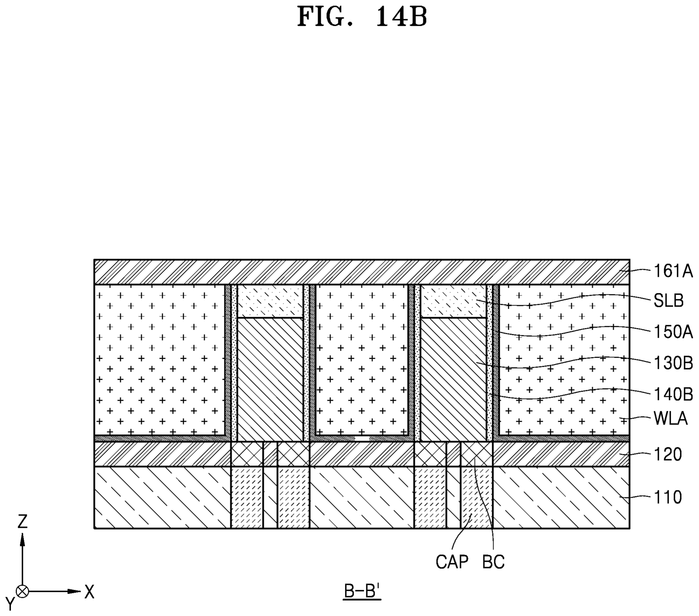

Referring to FIGS. 14A and 14B, an upper capping preparation layer 161A may be formed on the upper surface of the sacrificial pattern layer SLB, the upper surface of the channel pattern layer 140B, the upper surface of the gate dielectric preparation layer 150A, and the upper surface of the word line preparation layer WLA. For example, the upper capping preparation layer 161A may include silicon nitride.

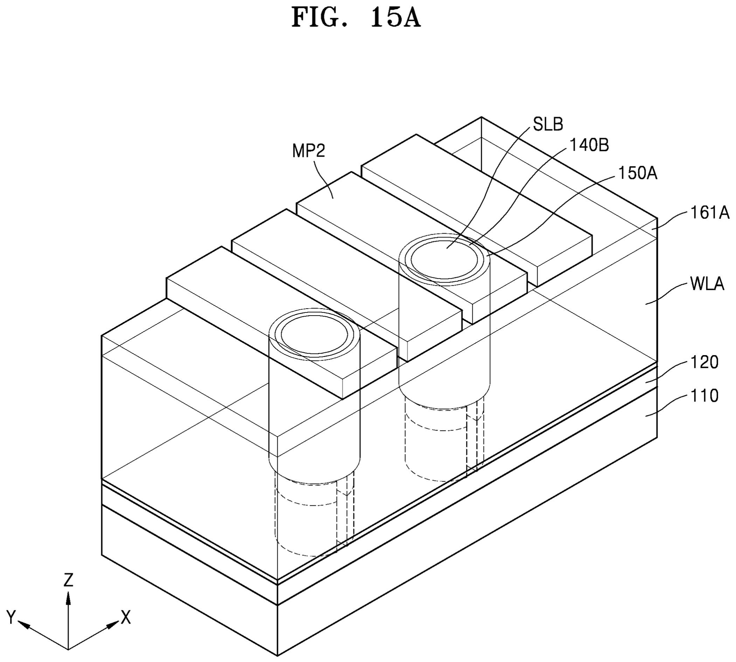

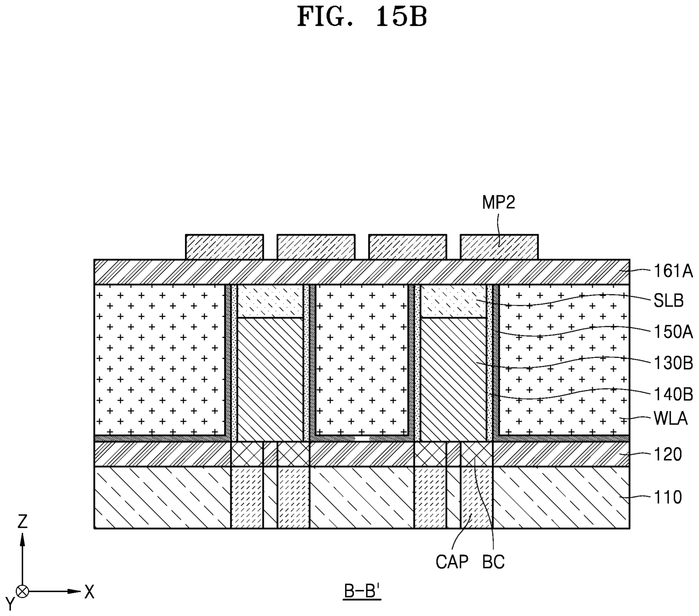

Referring to FIGS. 15A and 15B, a second photoresist may be applied on the upper capping preparation layer 161A and then patterned by a second photolithography process to form a second mask pattern MP2. A region in which a plurality of vertical channel transistors VCT to be described below is to be formed may be defined by the second mask pattern MP2.

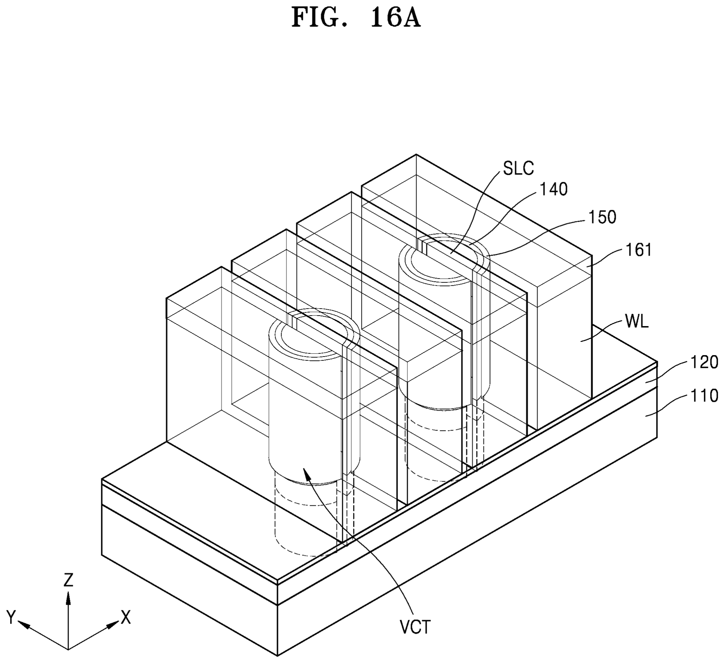

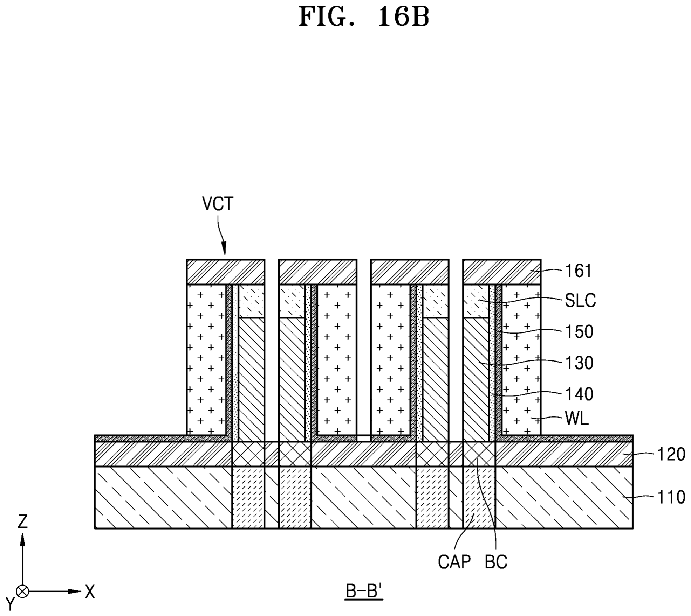

Referring to FIGS. 16A and 16B, an etching process using the second mask pattern MP2 (see FIG. 15A) as an etching mask may be performed to form the upper capping layer 161, a sacrificial structure layer SLC, the vertical channel layer 140, the gate dielectric layer 150, and the word line WL.

According to the etching process, a pair of mold layers 130 facing each other, a pair of sacrificial structure layers SLC facing each other, a pair of vertical channel layers 140 facing each other, a pair of gate dielectric layers 150 facing each other, a pair of word lines WL facing each other, and a pair of upper capping layers 161 facing each other may be formed on a pair of buried contacts BC facing each other. That is, the plurality of vertical channel transistors VCT may be formed.

For example, each of the pair of mold layers 130 and the pair of sacrificial structure layers SLC may be formed such that semicylindrical-shaped structures face each other. In addition, each of the pair of vertical channel layers 140 and the pair of gate dielectric layers 150 may be formed such that hollow semicylindrical-shaped structures surrounding the semicylindrical shapes, respectively, face each other.

In addition, each of the pair of word lines WL may be formed to extend in a wave shape in the second horizontal direction (the Y direction) while surrounding the outer walls of the plurality of gate dielectric layers 150 arranged in a zigzag manner. In addition, each of the pair of upper capping layers 161 may be formed to extend in a bar shape in the second horizontal direction (the Y direction). After the etching process, the second mask pattern MP2 (see FIG. 15A) may be removed.

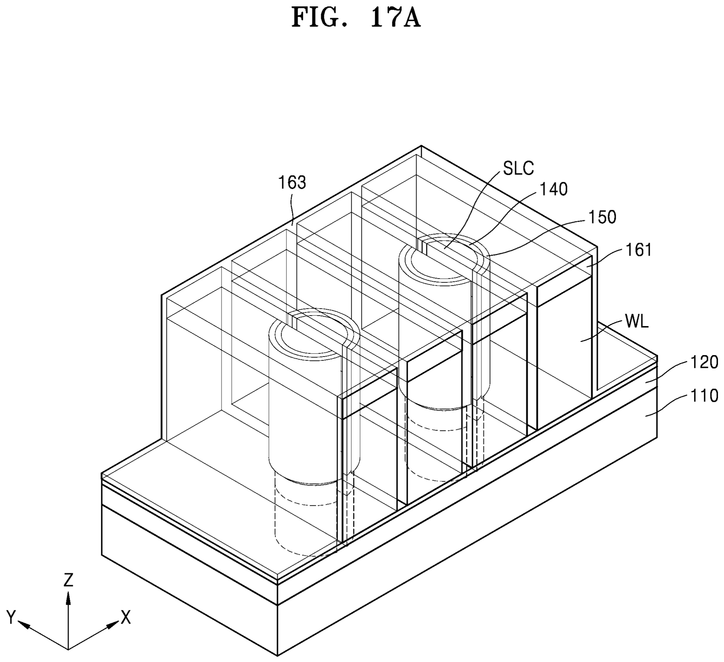

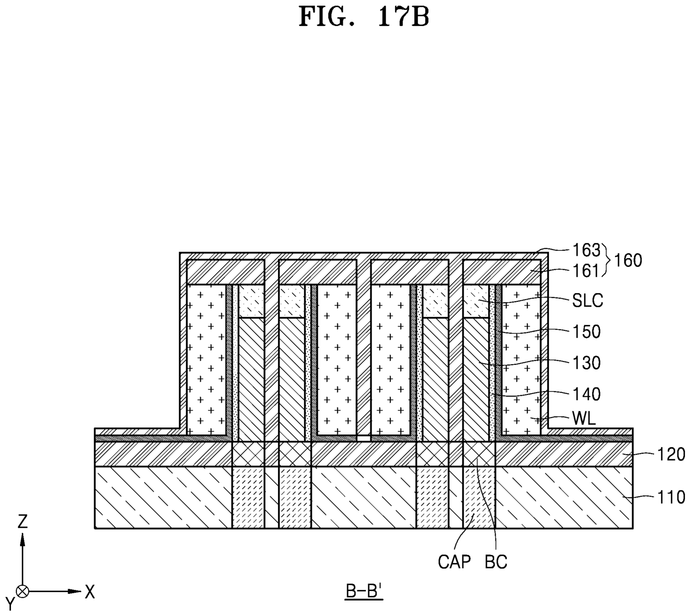

Referring to FIGS. 17A and 17B, the outer capping layer 163 may be formed to conformally cover exposed surfaces of the mold layer 130, the sacrificial structure layer SLC, the word line WL, and the upper capping layer 161. In some example embodiments, the outer capping layer 163 and the upper capping layer 161 may include the same insulating material, for example, silicon nitride.

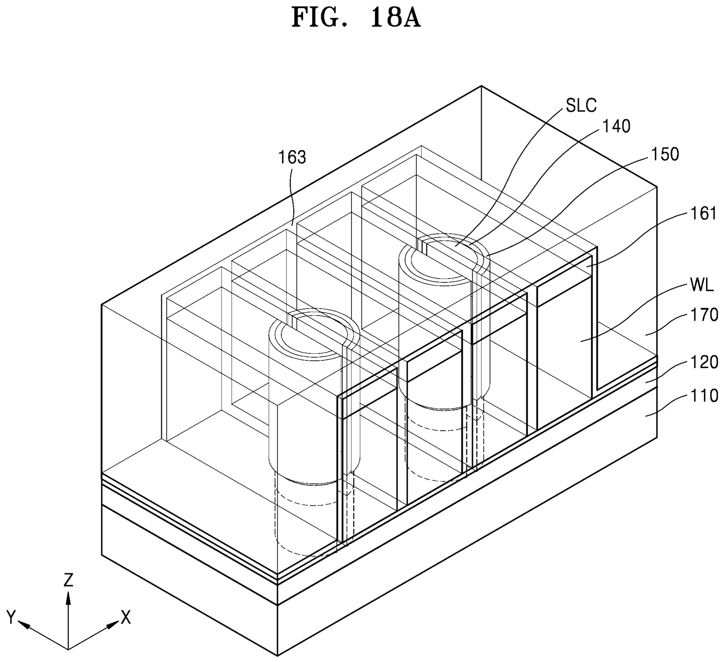

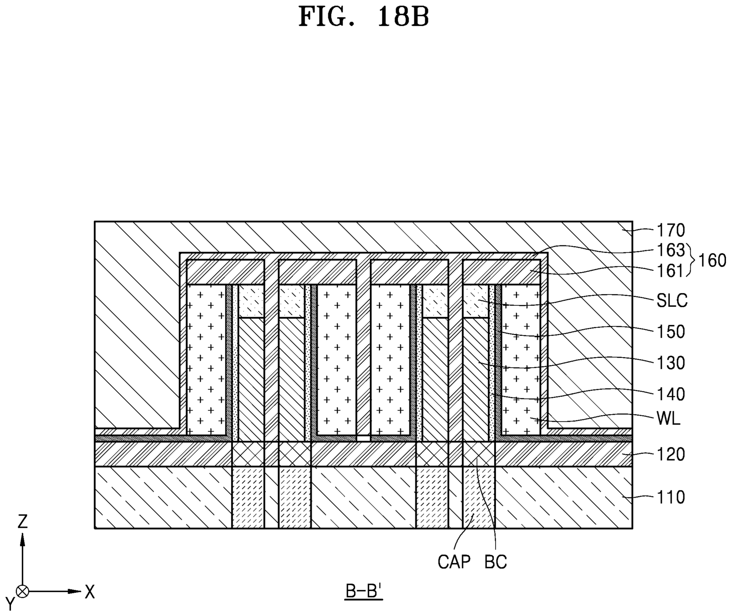

Referring to FIGS. 18A and 18B, the interlayer insulating material 170 may be formed to cover the outer capping layer 163. In some example embodiments, the interlayer insulating material 170 and the outer capping layer 163 may include different insulating materials, and the interlayer insulating material 170 may include, for example, silicon oxide.

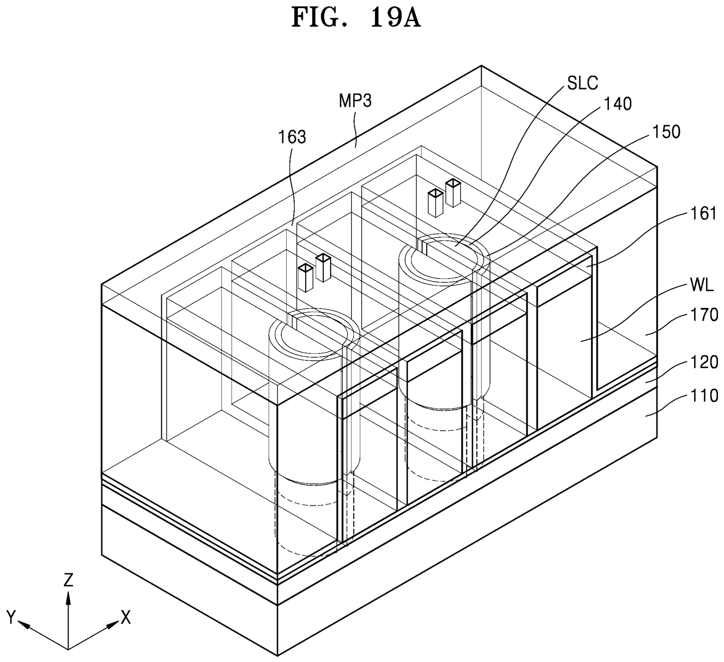

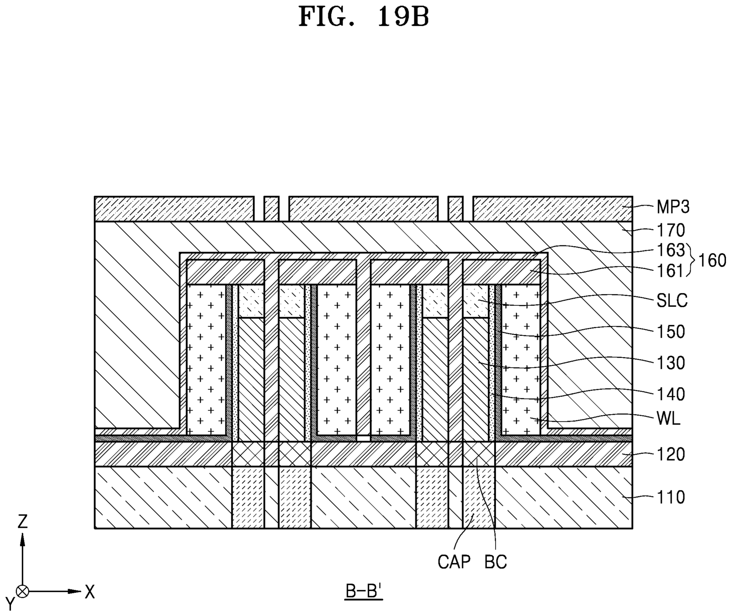

Referring to FIGS. 19A and 19B, a third photoresist may be applied on the interlayer insulating material 170 and then patterned by a third photolithography process to form a third mask pattern MP3. A plurality of openings OP to be described below may be defined by the third mask pattern MP3.

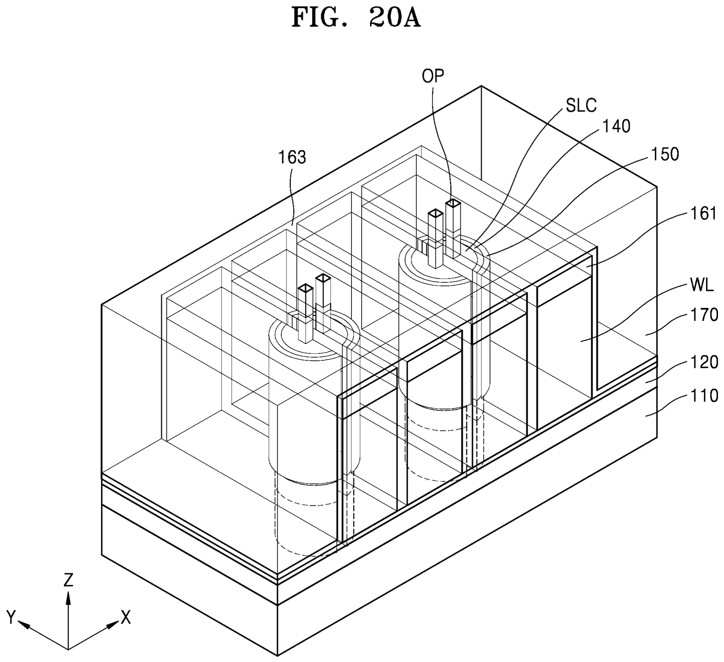

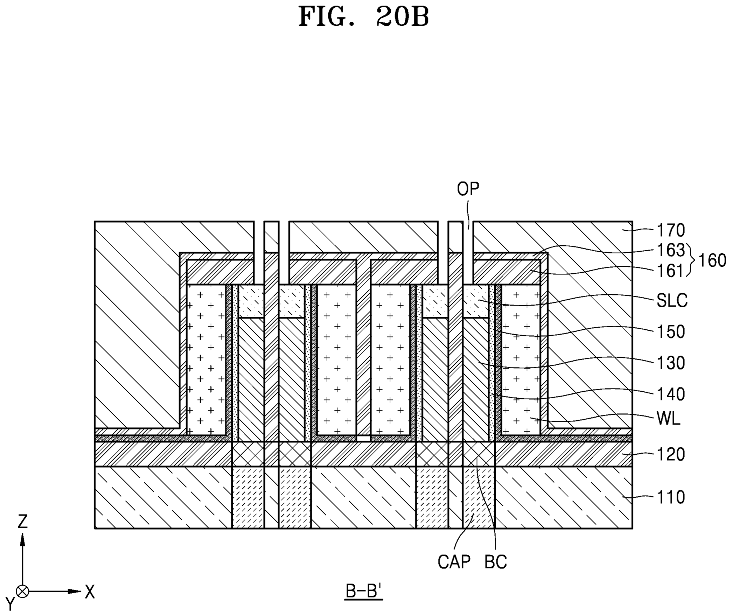

Referring to FIGS. 20A and 20B, an etching process using the third mask pattern MP3 (see FIG. 19A) as an etching mask may be performed to form the plurality of openings OP through which portions of the upper surfaces of a plurality of sacrificial structure layers SLC are exposed, respectively.

According to the etching process, each of the plurality of openings OP may be formed by etching a portion of the interlayer insulating material 170, a portion of the outer capping layer 163, and a portion of the upper capping layer 161 in the vertical direction (the Z direction), and portions of the upper surfaces of the plurality of sacrificial structure layers SLC may be exposed through the plurality of openings OP, respectively. After the etching process, the third mask pattern MP3 (see FIG. 19A) may be removed.

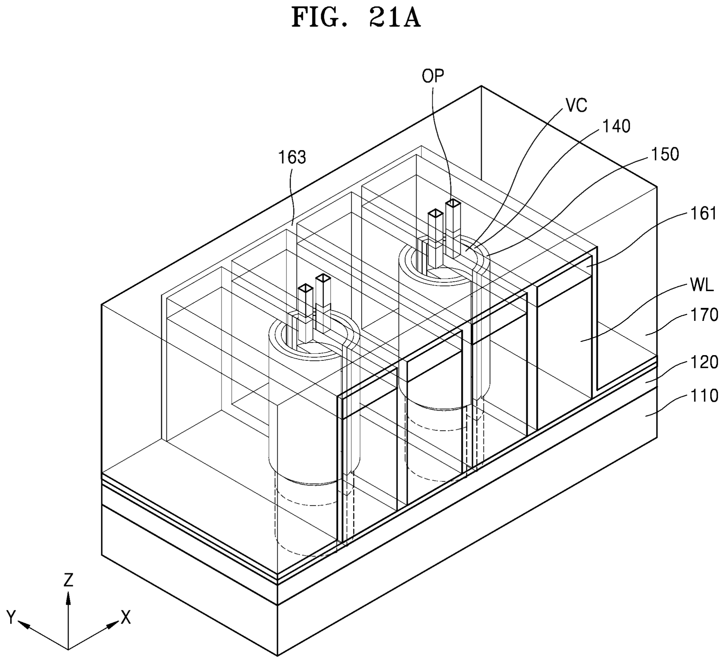

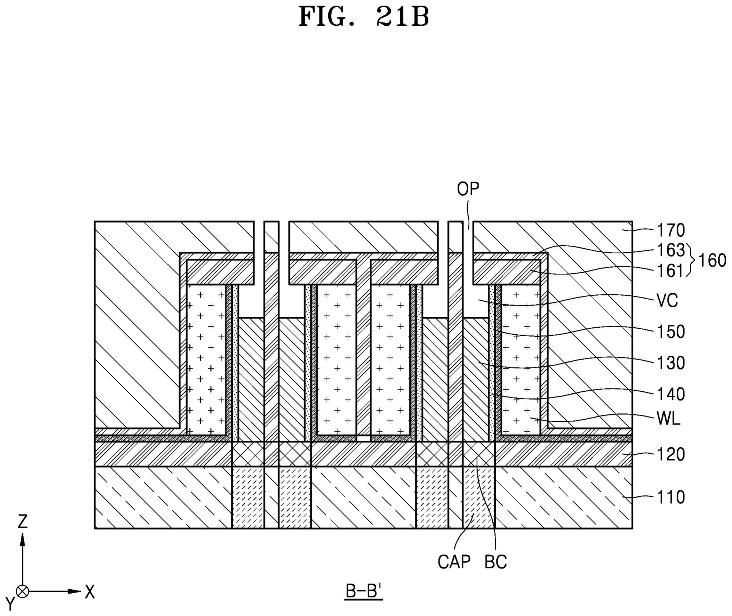

Referring to FIGS. 21A and 21B, all of the plurality of sacrificial structure layers SLC (see FIG. 20A) may be removed through the plurality of openings OP to form a plurality of vacant spaces VC in the removed places. Accordingly, the upper surfaces of the plurality of mold layers 130 and portions of the inner walls in upper regions of the plurality of vertical channel layers 140 may be exposed.

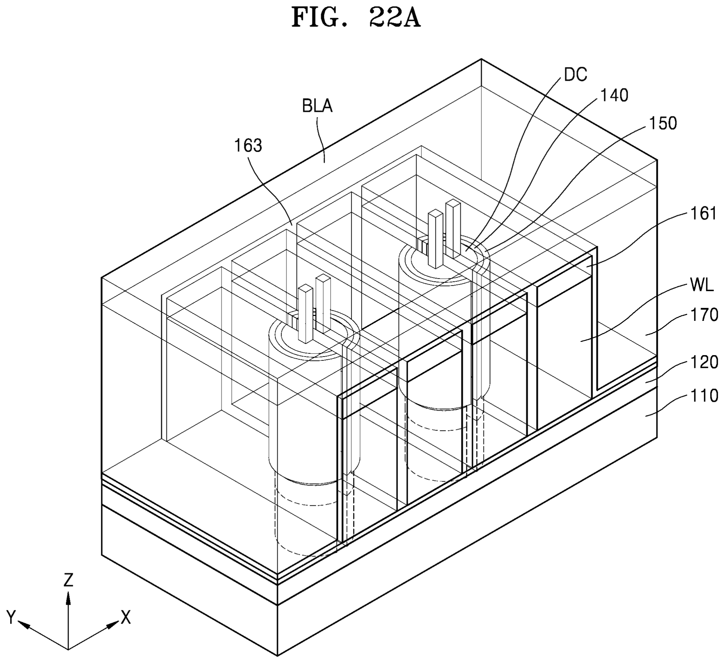

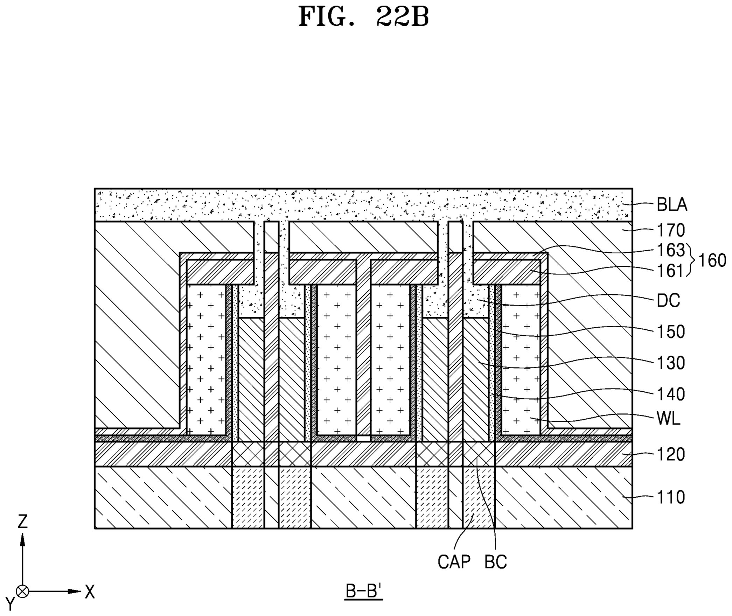

Referring to FIGS. 22A and 22B, a bit line preparation layer BLA may be formed to fill all of the plurality of openings OP and the plurality of vacant spaces VC exposed through the plurality of openings OP and cover the upper surface of the interlayer insulating material 170. Accordingly, the plurality of direct contacts DC may be formed in the regions in which the plurality of sacrificial structure layers SLC (see FIG. 20A) were placed.

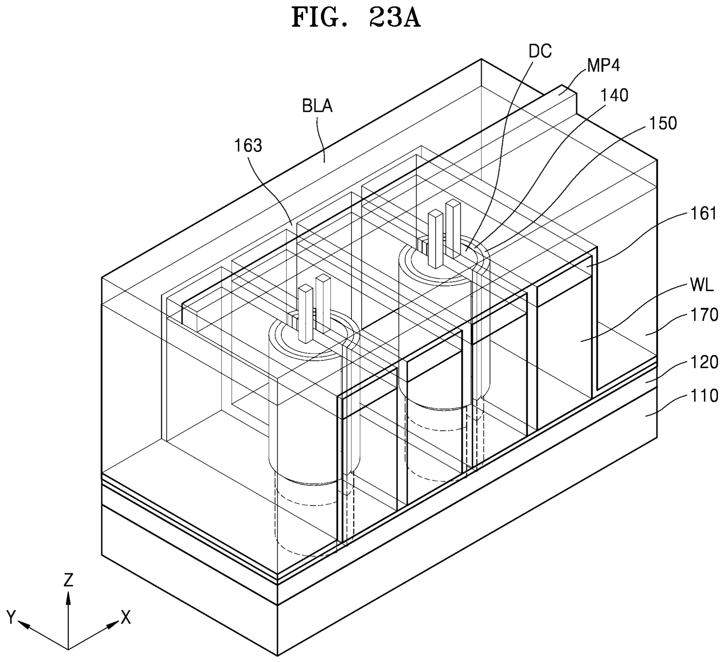

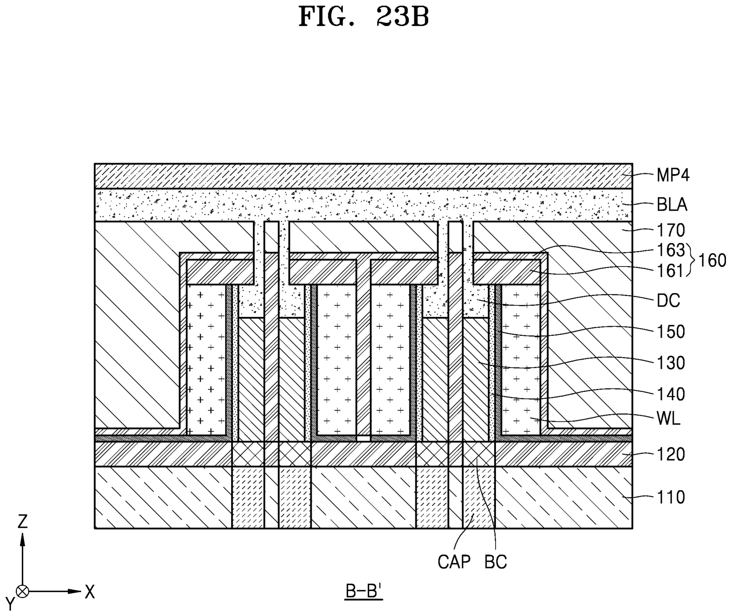

Referring to FIGS. 23A and 23B, a fourth photoresist may be applied on the bit line preparation layer BLA and then patterned by a fourth photolithography process to form a fourth mask pattern MP4. The bit line BL to be described below may be defined by the fourth mask pattern MP4.

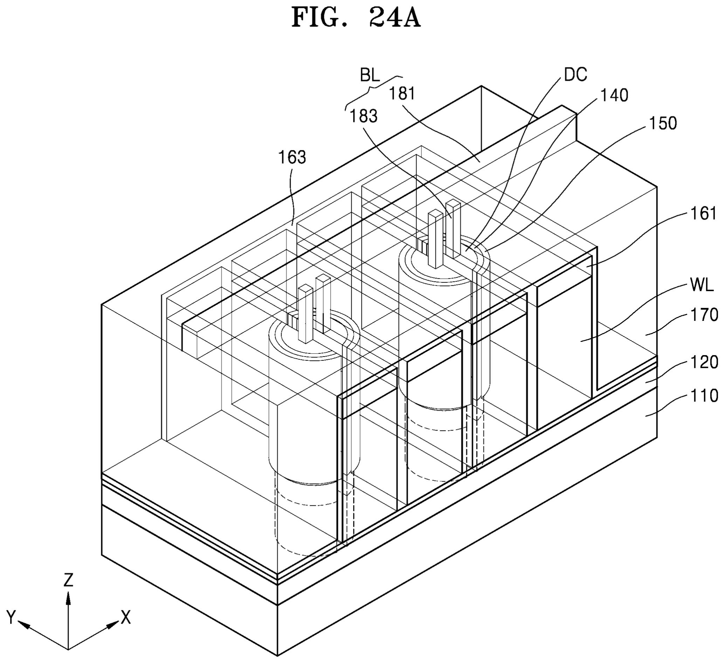

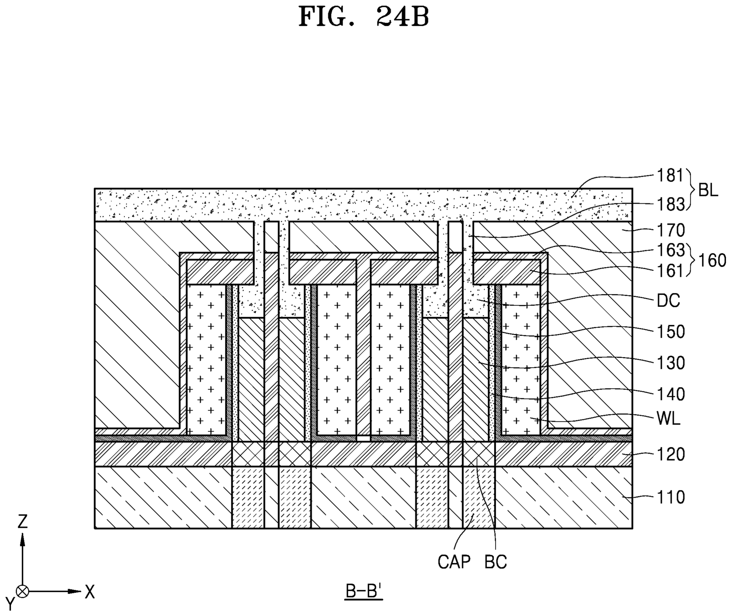

Referring to FIGS. 24A and 24B, an etching process using the fourth mask pattern MP4 (see FIG. 23A) as an etching mask may be performed to form the bit line BL.

According to the etching process, the bit line BL including the horizontal extension portion 181 extending lengthwise in the first horizontal direction (the X direction) and the plurality of posts 183 protruding in the vertical direction (the Z direction) from the horizontal extension portion 181 may be formed. One post 183 in the bit line BL may be formed such that the lower surface of the one post 183 is in contact with the upper surface of one direct contact DC. After the etching process, the fourth mask pattern MP4 (see FIG. 23A) may be removed.

Referring back to FIGS. 1 to 5, the bit line insulating layer (not shown) extending in the first horizontal direction (the X direction) may be formed on the sidewall of the bit line BL.

The semiconductor device 10 according to an example embodiment of the inventive concepts may be manufactured by the method of manufacturing a semiconductor device, which has been described above.

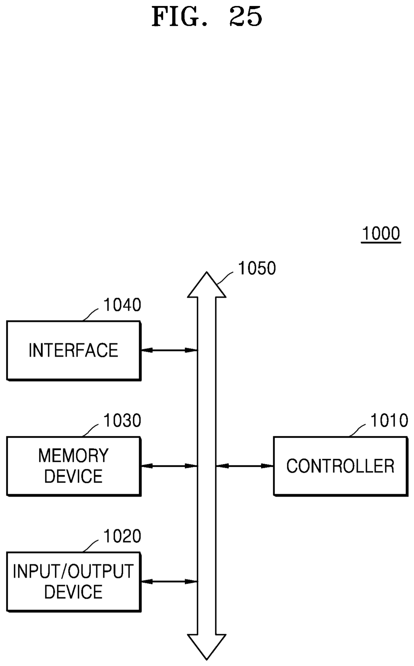

FIG. 25 is a block diagram illustrating a system 1000 including a semiconductor device according to an example embodiment.

Referring to FIG. 25, the system 1000 may include a controller 1010, an input/output device 1020, a memory device 1030, an interface 1040, and a bus 1050.

The system 1000 may be a mobile system or a system for transmitting or receiving information. In some example embodiments, the mobile system may be a portable computer, a web tablet, a mobile phone, a digital music player, or a memory card.

The controller 1010 may control an execution program in the system 1000 and include a microprocessor, a digital signal processor, a microcontroller, or a similar device.

The input/output device 1020 may be used to input or output data to or from the system 1000. The system 1000 may be connected to an external device, for example, a personal computer or a network, by using the input/output device 1020 and exchange data with the external device. The input/output device 1020 may be, for example, a touch screen, a touch pad, a keyboard, or a display.

The memory device 1030 may store data for an operation of the controller 1010 or store data processed by the controller 1010. The memory device 1030 may include the semiconductor device 10 according to an example embodiment of the inventive concepts, which has been described above.

The interface 1040 may be a data transmission passage between the system 1000 and the external device. The controller 1010, the input/output device 1020, the memory device 1030, and the interface 1040 may communicate with each other via the bus 1050.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While the inventive concepts have been particularly shown and described with reference to some example embodiments thereof, it will be understood that various changes in form and details may be made therein without departing from the scope of the following claims.

## Claims

1. A semiconductor device comprising:
a capacitor structure (CAP);
a buried contact (BC) on the capacitor structure (CAP);
a hollow semicylindrical-shaped vertical channel layer (140) extending on the buried contact (BC) in a vertical direction (Z), the vertical channel layer (140) having an inner wall and an outer wall;
a hollow semicylindrical-shaped gate dielectric layer (150) surrounding the outer wall of the vertical channel layer (140), the gate dielectric layer (150) having an inner wall and an outer wall;
word lines (WL) spaced apart from each other in a first horizontal direction (X), the word lines (WL) extending in a second horizontal direction (Y) intersecting the first horizontal direction (X), and one of the word lines (WL) being in contact with the outer wall of the gate dielectric layer (150);
a semicylindrical-shaped direct contact (DC) in contact with the inner wall of the vertical channel layer (140); and
a bit line (BL) having a post (183) in contact with an upper surface of the direct contact (DC), the bit line (BL) extending in the first horizontal direction (X).

2. The semiconductor device of claim 1, wherein
the vertical channel layer (140) is one of a plurality of vertical channel layers (140), and
in a top view, an adjacent pair of vertical channel layers (140P), from among the plurality of vertical channel layers (140), facing each other in the first horizontal direction (X) have a mirror-symmetric structure, and a virtual line drawn by the adjacent pair of vertical channel layers (140P) has a circular shape.

3. The semiconductor device of claim 2, wherein, in a top view, the adjacent pair of vertical channel layers (140P) defines a honeycomb structure with other pairs of vertical channel layers (140P) adjacent thereto.

4. The semiconductor device of claim 3, wherein
the gate dielectric layer (150) is one of an adjacent pair of gate dielectric layers (150), the adjacent pair of vertical channel layers (140P) facing each other to have a mirror-symmetric structure in the first horizontal direction (X), a virtual line drawn by the adjacent pair of gate dielectric layers (150) being a circular shape, and
one of the word lines (WL) is in contact with one of the adjacent pair of gate dielectric layers (150).

5. The semiconductor device of claim 4, wherein the one of the word lines (WL) extends in a wave shape in the second horizontal direction (Y).

6. The semiconductor device of any one of claims 1 to 5, wherein a lower surface of the direct contact (DC) is not in contact with the vertical channel layer (140), and a rounded sidewall of the direct contact (DC) is in contact with the vertical channel layer (140).

7. The semiconductor device of any one of claims 1 to 6, wherein a first radius (R5) of the direct contact (DC) is less than a second radius (R3) of the vertical channel layer (140), and the second radius (R3) of the vertical channel layer (140) is less than a third radius (R4) of the gate dielectric layer (150).

8. The semiconductor device of claim 7, wherein the buried contact (BC) has a semicylindrical shape, and a fourth radius (R1) of the buried contact (BC) is greater than or equal to the second radius (R3) of the vertical channel layer (140).

9. The semiconductor device of any one of claims 1 to 8, wherein an uppermost surface of the direct contact (DC), an uppermost surface of the vertical channel layer (140), and an uppermost surface of the gate dielectric layer (150) are at a same vertical level.

10. The semiconductor device of any one of claims 1 to 9, wherein the direct contact (DC), the post (183), and the bit line (BL) are an integral body.

11. The semiconductor device according to claim 1, wherein:
the capacitor structure (CAP) is one of a pair of capacitor structures (CAP) facing each other;
the buried contact (BC) is one of a pair of buried contacts (BC) facing each other, the pair of buried contacts (BC) being on the pair of capacitor structures (CAP), respectively;
the vertical channel layer (140) is one of a pair of vertical channel layers (140P) extending on the pair of buried contacts (BC) in the vertical direction (Z), respectively, the pair of vertical channel layers (140P) facing each other and having hollow semicylindrical shapes with a first radius (R3);
the gate dielectric layer (150) is one of a pair of gate dielectric layers (150) surrounding the pair of vertical channel layers (140P), respectively, the pair of gate dielectric layers (150) facing each other and having hollow semicylindrical shapes with a second radius (R4), the second radius (R4) being greater than the first radius (R3);
one of the word lines (WL) being in contact with one of the pair of gate dielectric layers (150);
the direct contact (DC) is one of a pair of direct contacts (DC) in contact with inner sides of the pair of vertical channel layers (140P), respectively, the pair of direct contacts (DC) having semicylindrical shapes and facing each other; and
the bit line (BL) having a pair of posts (183) in contact with upper surfaces of the pair of direct contacts (DC), respectively.

12. The semiconductor device of claim 11, wherein, in a top view, the pair of vertical channel layers (140P) define a honeycomb structure with other pairs of vertical channel layers (140) adjacent thereto.

13. The semiconductor device of claim 12, wherein
the honeycomb structure defines a first hexagonal structure, in which most adjacent six pairs of vertical channel layers (140) are at vertices of a hexagon (Hec) and the pair of vertical channel layers (140P) are at a central point (Hc) of the hexagon (Hec),
the six pairs of vertical channel layers (140) at the vertices (H1 to H6) of the first hexagonal structure are at central points of different six hexagonal structures, respectively, and
the pair of vertical channel layers (140P) at the central point of the first hexagonal structure are shared as one pair of vertical channel layers (140P) at vertices of the six different hexagonal structures.

14. The semiconductor device of claim 13, wherein
the bit line (BL) is one of a plurality of bit lines (BL), and
in a top view, a number of the plurality of bit lines (BL) passing through an inside of the first hexagonal structure is greater than a number of the word lines (WL) passing through an inside of the first hexagonal structure.

15. The semiconductor device of claim 14, wherein, in a top view, one of the plurality of bit lines (BL) passes through the central point (Hc) of the first hexagonal structure, and the one of the word lines (WL) does not pass through the central point (Hc) of the first hexagonal structure.
